# EUROPEAN PATENT APPLICATION

(11) **EP 3 835 451 A1**
(43) Date of publication of application: **16.06.2021**
(21) Application number: 20208358.0
(22) Date of filing: 18.11.2020
(51) Int. Cl.: C23C 4/02, C23C 4/11, C23C 4/134, C23C 4/18, C23C 14/02, C23C 14/08, C23C 14/58, C23C 28/04, C23C 28/00

(54) **THERMAL BARRIER COATING**

(30) Priority: 12.12.2019 GB 201918278
(71) Applicant: Rolls-Royce plc, London N1 9FX (GB)
(72) Inventor: Brewster, James, Derby, Derbyshire DE24 8BJ (GB); Chalk, Christine, Derby, Derbyshire DE24 8BJ (GB); Appleton, Matthew, Derby, Derbyshire DE24 8BJ (GB)
(74) Representative: Rolls-Royce plc

(57) **Abstract**

The present disclosure relates to a thermal barrier coating for coating a substrate. The thermal barrier coating may comprise an inner ceramic layer (e.g. 7YSZ) having a columnar grain structure and a first outer ceramic layer (e.g. 7YSZ) having a branched grain structure. The thermal barrier coating further comprises a nucleation layer (which may comprise alumina or tantala), interposed between the inner ceramic layer and the first outer layer. The layers can be deposited by PVD using substantially contact deposition parameters because the nucleation layer induces branching in the first outer ceramic layer.

## Description

### Field of the Disclosure

The present disclosure relates to thermal barrier coatings for protection of components against environmental contaminants. The present disclosure also relates to components (e.g. gas turbine engine components) with such coatings and a method for preparing such coated components.

### Background of the Disclosure

Gas turbine engines comprise a number of components (e.g. blades, vanes, nozzles and shrouds in the combustor or turbine engine sections) that are provided with a thermal barrier coating barrier to limit the exposure of the component to the operating temperature of the gas turbine engine.

The thermal barrier coating usually comprises a ceramic material, such as a chemically (metal oxide) stabilized zirconia, for example, yttria-stabilized zirconia, scandia-stabilized zirconia, calcia-stabilized zirconia, and magnesia-stabilized zirconia. The surface of the component typically comprises a bond coat layer for adhesion to the ceramic material deposited thereon.

Thermal barrier coatings may be deposited by physical vapor deposition techniques. Typically, these thermal barrier coatings comprise a columnar ceramic structure; this columnar grain structure allows these thermal barrier coatings to tolerate strains occurring during thermal cycling and to reduce stresses due to the differences between the coefficient of thermal expansion of the component and the thermal barrier coating.

At the high temperatures within the combustor/turbine sections of an operating gas turbine engine, environmental contaminants (in particular oxides of calcium, magnesium, aluminum, silicon), can form liquid or molten calcium-magnesium-aluminum-silicon-oxide compositions (hereinafter referred to as CMAS compositions). These CMAS compositions can dissolve the thermal barrier coating or can infiltrate its inter-columnar gaps. Upon cooling within the columnar grain structure, the infiltrated CMAS solidifies and reduces the coating strain/stress tolerance. This can result in cracking and ultimately delamination of the thermal barrier coating material. This, in turn leads to the loss of the thermal protection provided to the component.

In order to try and protect the columnar grain structure of the ceramic layer and thus preserve the thermal stress/strain tolerance of the thermal barrier coating, it is known to deposit a second (high dopant) ceramic layer (e.g. gadolinia stabilized zirconia/hafnia) onto a (low dopant) columnar ceramic layer (e.g. yttria stabilized zirconia/hafnia), the second layer having a branched or feathered structure. The branched grain structure results in a more tortuous porous structure that is more resistant to penetration of the CMAS composition and thus protects the underlying columnar ceramic layer.

One problem with this known combination of an inner columnar layer and outer branched layer is that markedly different deposition parameters are required to achieve the branched grain structure than those needed for the deposition of the columnar layer. This makes the process of forming the dual layer thermal barrier coating difficult to implement within current industrial scale coating equipment.

Other attempts to limit CMAS composition corrosion of ceramic thermal barrier coatings have involved co-depositing a non-alumina ceramic and up to 50wt% alumina as an outer layer in a thermal barrier coating. The alumina reacts with the CMAS compositions in a crystallization reaction limiting penetration of the CMAS down any pores/channels in the ceramic layer. However, the porous structure of the alumina/non-alumina ceramic layer does not itself present any physical barrier to penetration should any unreacted CMAS compositions remain.

It would be desirable to provide a thermal barrier coating that ameliorates the problems of the known thermal barrier coatings.

### Summary of the Disclosure

According to a first aspect there is provided a thermal barrier coating for coating a substrate, the thermal barrier coating comprising:
an inner ceramic layer having a columnar grain structure; and
a first outer ceramic layer having a branched grain structure,
wherein the thermal barrier coating further comprises a nucleation layer interposed between the inner ceramic layer and the first outer layer.

It has been found that depositing a nucleation layer on an inner columnar ceramic layer, causes branching of a subsequently deposited outer ceramic layer without the need for the markedly different deposition parameters that are typically required to deposit columnar ceramic and branched ceramic materials. This results in a considerably simpler process for forming the coating which, in turn reduces manufacturing time and costs for the component.

In some embodiments, the nucleation layer comprises an oxide or silicate having a different crystal structure to the inner and/or outer ceramic layer. For example, if the inner and/or outer ceramic layer comprises a tetragonal crystal structure, the nucleation layer may comprise a hexagonal close packed or orthorhombic crystal structure.

The nucleation layer may comprise one or more of:
- alumina (Al₂O₃);
- a rare-earth oxide or silicate (e.g. ytterbium or yttrium silicate or oxide); and/or
- a transition metal oxide (e.g. tantalum pentoxide/tantala(Ta₂O₅), nickel-chromium oxide or titania (TiO₂).

In preferred embodiments, the nucleation layer comprises alumina or tantala. It may further comprise titania.

The inner ceramic layer may comprise a zirconia or hafnia or titania, e.g. a stabilised zirconia/hafnia/titania. The stabilised zirconia/hafnia/titania may be stabilised with a rare earth element oxide such as yttria, gadolinia, or scandia, or a combination of rare earth element oxides. Suitable yttria-stabilized zirconia/hafnia/titania can include around 3-10 wt% and more preferably 7-9wt% yttria.

The inner ceramic layer has a columnar grain structure i.e. it comprises a series of substantially parallel columns extending perpendicularly towards the nucleation layer. The inner ceramic layer further comprises inter-columnar gaps for imparting stress/strain tolerance. The columnar grain structure of a ceramic layer is clearly visible using scanning electron microscopy.

The first outer ceramic layer may be formed of the same or different ceramic material as the inner ceramic layer. It may comprise a zirconia or hafnia or titania, e.g. a stabilised zirconia/hafnia/titania. The stabilised zirconia/hafnia/titania may be stabilised with up to 80wt% of a rare earth element oxide such as yttria, gadolinia, or scandia, or a combination of rare earth element oxides. Suitable yttria-stabilized zirconia/hafnia/titania can include around 3-10wt% and more preferably 7-9wt% yttria.

The first outer ceramic layer has a branched grain structure i.e. it comprises branched or feathered grain structure, the branches directed generally away from the nucleation layer. The outer ceramic layer comprises a more tortuous porous structure than that provided by the inter-columnar gaps in the outer ceramic layer. The branched/feathered structure of a ceramic layer is clearly visible using scanning electron microscopy.

The thermal barrier coating may further comprise a second nucleation layer and a second outer ceramic layer overlying the first nucleation layer and first outer ceramic layer (with the second nucleation layer interposed between the first and second outer ceramic layers). The second nucleation layer will induce further branching in the second outer ceramic layer.

The thermal barrier coating may comprise at least one further pair of nucleation and outer ceramic layers overlying the second nucleation layer and the second outer ceramic layers. Thus, the thermal barrier coating may comprise an inner columnar ceramic layer and an alternating arrangement of nucleation layers and outer branched ceramic layers.

There may be greater than 5, e.g. greater than 10, 20 or 30, such as greater than 40, 50 or 60, for example, greater than 70, 80, 90 or 100 nucleation/outer branched ceramic layers.

The second/further nucleation layer(s) may be the same as the first nucleation layer.

The second/further outer ceramic layer(s) may be the same as the inner ceramic layer and/or the first outer ceramic layer.

The inner ceramic layer may have a thickness of between 50-150 microns.

The nucleation layer may be thinner than the inner ceramic layer.

The/each nucleation layer may have a thickness of between 0.1 and 5 microns e.g. between 0.2 and 2 microns. The nucleation layers may be of uniform or variable thickness.

The or each outer ceramic layer may be thinner than the inner ceramic layer. The or each outer layer may be thicker than the nucleation layer. The outer ceramic layers may be of uniform or variable thickness.

The or each outer ceramic layer may have a thickness of between 0.3 and 10 microns.

Each of the inner ceramic layer, nucleation layer(s) and outer ceramic layer(s) may have a thickness of between 100-150 microns.

In the embodiments, the thermal barrier coating further comprises a bonding coat layer on an inner surface of the inner ceramic layer. The bond coat layer may comprise diffused platinum or a metallic alloy e.g. a metallic alloy comprising aluminium, silicon or chromium.

In a second aspect, there is provided a component comprising a substrate at least partially coated with the thermal barrier coating according to the first aspect.

The substrate may comprise a metal alloy such as a nickel, cobalt, and/or iron based alloy (e.g. a high temperature superalloy), a refractory metal or an inter-metallic.

In some embodiments, the metal component is a gas turbine engine component such as a blade, vane nozzle, shroud, liner or deflector.

In a third aspect, there is provided a method of coating a substrate with a thermal barrier coating, said method comprising:
depositing an inner layer of ceramic having a columnar grain structure on the substrate;
depositing a nucleation layer on the inner layer of ceramic; and
depositing an outer layer of ceramic on the nucleation layer such that the nucleation layer effects nucleation of branching within the outer layer of ceramic.

The method may comprise depositing a nucleation layer comprising one or more of:
- alumina (Al₂O₃);
- a rare-earth oxide or silicate (e.g. ytterbium or yttrium silicate or oxide); and/or
- a transition metal oxide (e.g. tantalum pentoxide/tantala(Ta₂O₅), nickel-chromium oxide or titania (TiO₂).

In preferred embodiments, the method may comprise depositing a nucleation layer comprising alumina or tantala optionally further comprise titania.

The method may comprise depositing a zirconia or hafnia or titania, e.g. a stabilised zirconia/hafnia/titania as the inner layer of ceramic. The stabilised zirconia/hafnia/titania may be stabilised with a rare earth element oxide such as yttria, gadolinia, or scandia, or a combination of rare earth element oxides. Suitable yttria-stabilized zirconia/hafnia/titania can include around 3-10 wt% and more preferably 7-9wt% yttria.

The method may comprise depositing a zirconia or hafnia or titania, e.g. a stabilised zirconia/hafnia/titania as the first outer layer of ceramic. The method may comprise depositing zirconia/hafnia/titania stabilised with up to 80 wt% of a rare earth element oxide such as yttria, gadolinia, or scandia, or a combination of rare earth element oxides. Suitable yttria-stabilized zirconia/hafnia/titania can include around 3-10wt% and more preferably 7-9wt% yttria.

The substrate may be as described for the second aspect.

In some embodiments, the method further comprises depositing a second nucleation layer on the outer layer of ceramic and depositing a second outer layer of ceramic on the second nucleation layer such that the second nucleation layer effects nucleation of branching within the second outer layer of ceramic.

In some embodiments, the method may comprise depositing at least one further pair of nucleation and outer ceramic layers overlying the second nucleation layer and the second outer ceramic layers.

In some embodiments, the method may comprise depositing 5 or more. For example, this may be 10 or more, 20 or more or 30 or more. Furthermore, this could be 40 or more, 50 or more or 60 or more. Alternatively, this could be 70 or more, 80 or more, 90 or more or 100 or more nucleation/outer ceramic layers.

The second/further outer ceramic layer(s) may be the same as the inner ceramic layer and/or the first outer ceramic layer.

In some embodiments, the method comprises depositing the layers using physical vapour deposition (PVD) e.g. electron beam-PVD, suspension plasma spraying (SPS), solution precursor plasma spraying (SPPS), plasma spray physical vapour deposition (PS_PVD) or directed vapour deposition (DVD).

In some embodiments, the method comprises depositing the layers using substantially constant deposition parameters (e.g. power, temperature, chamber pressure). In some embodiments, the method comprises depositing the layers using a substantially constant component (part) temperature. In some embodiments, the method comprises depositing the layers using a substantially constant chamber pressure. In some embodiments, the method comprises depositing the layers using a substantially constant vapour incidence angle. In some embodiments, the method comprises depositing the layers on a rotating component using a substantially constant rotational speed.

The method may further comprise an abrasive surface treatment step (e.g. grit or sandblasting or peening) on the substrate prior to deposition of the layers.

The method may further comprise deposition of a bond coat layer on the substrate prior to deposition of the inner layer of ceramic. The bond coat layer may be as described above for the first aspect. The bond coat layer may be formed by electroplating and then optionally by heat treating. For example, the bond coat layer may be formed by electroplating and heat-treating platinum. In other embodiments, the bond coat layer may be applied by a combination of electroplating platinum and deposition of aluminium by chemical vapour deposition optionally with intermediate heat-treatment operations.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

### Brief Description of the Drawings

Embodiments will now be described by way of example only, with reference to the Figures, in which:
**Figure 1a** is an SEM photograph of a single layer 7YSZ coating prior to CMAS attack;
**Figure 1b** is an SEM photograph of the single layer 7YSZ coating after CMAS attack;
**Figure 2a** is an SEM photograph of a first embodiment of a coating having an inner columnar ceramic layer and multiple nucleation and outer branched ceramic layers prior to CMAS attack;
**Figure 2b** is an enlarged section of Figure 2a;
**Figure 2c** is an SEM photograph of the first embodiment after CMAS attack;
**Figure 3a** is an SEM photograph of a second embodiment of a coating having an inner columnar ceramic layer and multiple nucleation and outer branched ceramic layers prior to CMAS attack;
**Figure 3b** is an enlarged section of Figure 3a;
**Figure 3c** is an SEM photograph of the second embodiment after CMAS attack; and
**Figure 3d** is an enlarged section of Figure 3c.

### Detailed Description and Experimental details

First, a comparative sample was prepared using a metallic nickel-based substrate which was treated by grit-blasting using #220 brown alumina and subsequently coated with an aluminide bond coat layer.

A ceramic layer having a columnar grain structure, a thickness of 135 microns and comprising 7-9wt% yttria-stabilised zirconia (7YSZ) was deposited on the substrate using electron beam-physical vapour deposition (EB-PVD) at a temperature of 980 °C, a power of 36 kW and a chamber pressure of 6x10⁻³ mbar.

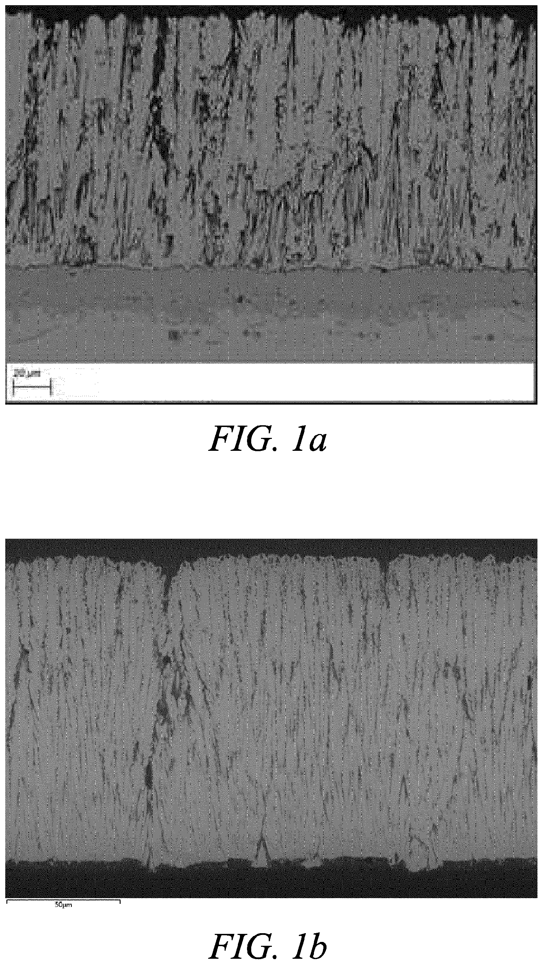

The resulting columnar ceramic layer is shown in **Figure 1a****.** The columnar grain structure is clearly visible with the ceramic layer comprising multiple parallel columns extending away perpendicularly to the surface of the substrate, the columns spaced by inter-columnar gaps. These gaps provide for thermal stress/strain tolerances by allowing independent movement of the columns.

Next, the CMAS resistance of the sample was tested by using an air spray gun to deposit an even film (having a loading of 15 mg/cm²) of a CMAS suspension comprising 35 mol% CaO, 10mol% MgO, 7 mol%Al₂O₃ and 48mol% SiO₂ in deionized water onto the ceramic layer. The sample was then exposed to a temperature of 1300 °C in a furnace for 30 minutes to induce CMAS attack. The sample was then allowed to cool before being sectioned for assessment.

**Figure 1b** shows the sample after CMAS attack. It can be seen that the sample has poor resistance to CMAS attack. The CMAS has penetrated the ceramic layer through the inter-columnar gaps to partially dissolve the ceramic material leading to degradation of the columnar grain structure as a result of sintering and merging of the columns. The degradation of the columns (and the resulting reduction in the inter-columnar gaps) reduces the stress/strain tolerance of the ceramic layer leading to premature failure and delamination of the layer.

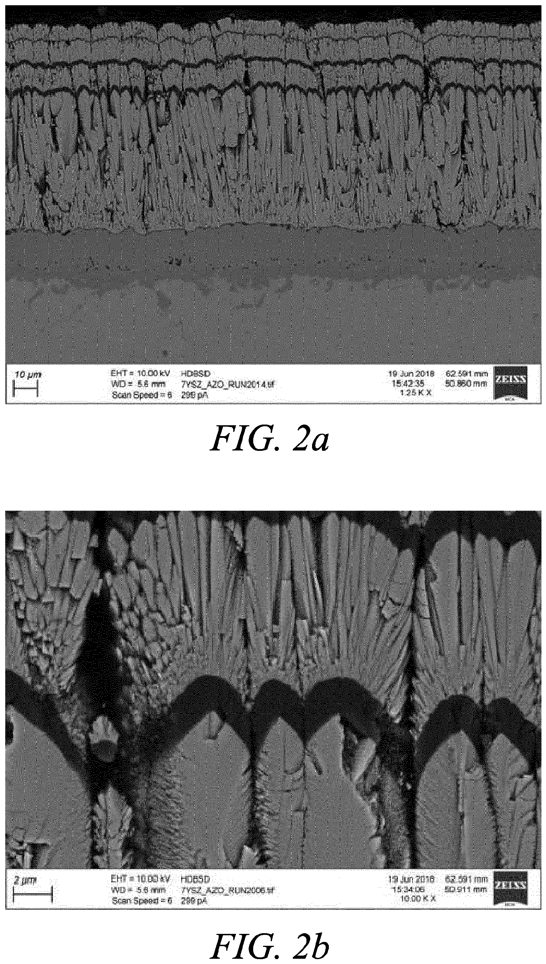

Next, a sample having a thermal barrier coating according to a first embodiment comprising an inner columnar ceramic (7YSZ) layer and three nucleation layers comprising alumina alternating with three outer branched ceramic (7YSZ) layers was prepared and is shown in **Figure 2a****.**

The first embodiment sample was prepared using a metallic nickel-based substrate which was treated by grit-blasting using #220 brown alumina and subsequently coated with a bond coat layer. The EB-PVD coater was set up with 7YSZ and alumina ingot materials and the deposition parameters (e.g. temperature, chamber pressure, power) were fixed. The temperature was fixed between 930-980 °C, the power at 36 kW and the chamber pressure at 6x10⁻³ mbar.

The 7YSZ ingot material was selected and using to deposit an inner ceramic layer having a columnar grain structure and a thickness of 57 microns. Next, without altering the deposition parameters, the ingot material selection was changed to alumina (using a moving hearth or jumping beam technology) and a first nucleation layer comprising alumina and having a thickness of 2 microns was deposited on the inner ceramic layer. The ingot material was then switched back (again without altering the deposition parameters) and a first outer layer of ceramic (7YSZ) having a thickness of 8 microns was deposited on top of the nucleation layer. The switching of ingot materials was repeated (retaining otherwise constant deposition parameters) to form a second alumina nucleation layer (2 micron thickness), second outer ceramic layer (9 micron thickness), third alumina nucleation layer (0.5 micron thickness) and third outer ceramic layer (5 micron thickness). Accordingly, the entire thermal barrier coating was formed using substantially constant deposition parameters.

It can be seen in Figure 2a that the inner ceramic layer has a columnar grain structure with inter-columnar gaps. The enlarged section shown in **Figure 2b** clearly shows the feathering within the outer ceramic layers caused as a result of side branching induced by the alumina nucleation layers.

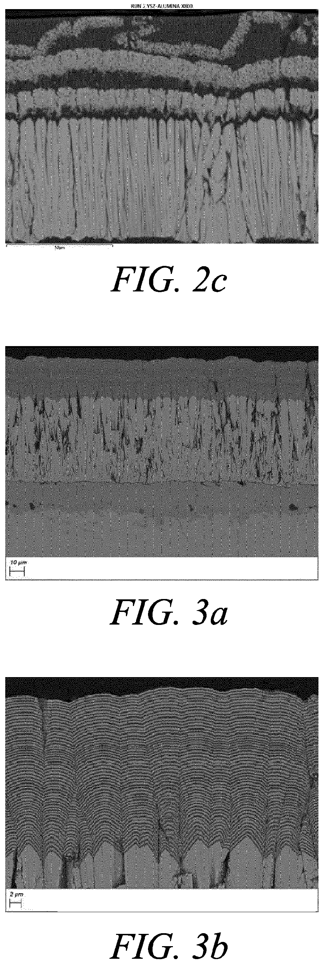

Next, a sample having a thermal barrier coating according to a second embodiment comprising an inner columnar ceramic (7YSZ) layer (68 micron thickness) and approximately 100 nucleation layers comprising alumina (0.2 micron thickness) alternating with approximately 100 outer branched ceramic (7YSZ) layers (0.4 micron thickness) was prepared in the same manner as the first embodiment sample and is shown in Figure 3a. **Figure 3b** clearly shows the alternating alumina and branched/feathered outer ceramic layers.

Next, the CMAS resistance of the first and second embodiment thermal barrier coatings was tested by using an air spray gun to deposit an even film (having a loading of 15 mg/cm²) of a CMAS suspension comprising 35 mol% CaO, 10mol% MgO, 7 mol% Al₂O₃ and 48mol% SiO₂ in deionized water onto the outermost ceramic layer. The first and second embodiment samples were then exposed to a temperature of 1300 °C in a furnace for 30 minutes to induce CMAS attack. The samples were allowed to cool before being sectioned for assessment.

**Figure 2c** shows the first embodiment sample after CMAS attack. It can be seen that the first embodiment thermal barrier coating has improved resistance to CMAS attack. The branched outer ceramic layers have undergone partial dissolution by the penetrating molten CMAS but the branching has limited CMAS penetration to the inner columnar ceramic layer such that the column grain structure and inter-columnar gaps remain.

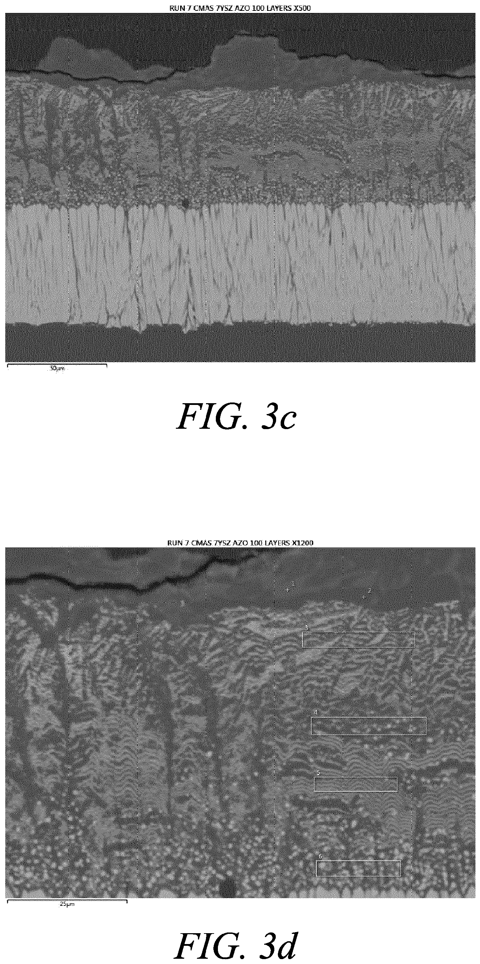

**Figures 3c and 3d** show the second embodiment sample after CMAS attack. It can be seen that the second embodiment thermal barrier coating has even greater improved resistance to CMAS attack. The numerous branched outer ceramic layers have significantly limited CMAS penetration to the inner columnar ceramic layer such that the column grain structure and inter-columnar gaps remain. Figure 3d shows the dissolution and sintering of the outer ceramic layers which leads to a dense protective barrier limiting further penetration of molten CMAS.

Protection of the columnar inner ceramic provides a thermal barrier coating which maintains its stress/strain tolerance after CMAS attack.

It will be understood that the disclosure is not limited to the embodiments above-described and various modifications and improvements can be made without departing from the concepts described herein. Except where mutually exclusive, any of the features may be employed separately or in combination with any other features and the disclosure extends to and includes all combinations and sub-combinations of one or more features described herein.

## Claims

1. A thermal barrier coating for coating a substrate, the thermal barrier coating comprising:
at least an inner ceramic layer having a columnar grain structure; and
at least a first outer ceramic layer having a branched grain structure,
wherein the thermal barrier coating further comprises a nucleation layer interposed between the inner ceramic layer and the first outer layer.

2. The thermal barrier coating according to claim 1 wherein the nucleation layer comprises one or more of: alumina (Al₂O₃); a rare-earth oxide or silicate; and/or a transition metal oxide.

3. The thermal barrier coating of claim 2 wherein the nucleation layer comprises alumina or tantala.

4. The thermal barrier coating of any one of claims 1 to 3 comprising a second nucleation layer and a second outer ceramic layer having a branched grain structure overlying the first nucleation layer and first outer ceramic layer with the second nucleation layer interposed between the first and second outer ceramic layers.

5. The thermal barrier coating of any one of claims 1 to 4 comprising greater than 50 pairs of alternating nucleation layers and outer ceramic layers having a branched grain structure.

6. The thermal barrier coating of any one of claims 1 to 5 wherein the inner ceramic layer and the/each outer ceramic layer is independently selected from a zirconia or hafnia or titania.

7. The thermal barrier coating according to claim 6 wherein the inner ceramic layer and the/each outer ceramic layer is independently selected from a zirconia, hafnia, titania stabilised with one or more rare earth element oxide.

8. The thermal barrier coating according to claim 7 wherein the inner ceramic layer and the/each outer ceramic layer is yttria-stablised zirconia or hafnia.

9. A component comprising a substrate at least partially coated with the thermal barrier coating according to any one of claims 1 to 8.

10. The component according to claim 9 wherein the component is a gas turbine engine component comprising a blade, vane nozzle, shroud, liner or deflector.

11. A method of coating a substrate with a thermal barrier coating, said method comprising:
depositing an inner layer of ceramic having a columnar grain structure on the substrate;
depositing a nucleation layer on the inner layer of ceramic; and
depositing an outer layer of ceramic on the nucleation layer such that the nucleation layer effects nucleation of branching within the outer layer of ceramic.

12. The method of claim 11 further comprising depositing a second nucleation layer on the outer layer of ceramic and depositing a second outer layer of ceramic on the second nucleation layer such that the second nucleation layer effects nucleation of branching within the second outer layer of ceramic.

13. The method of claim 11 or 12 further comprising depositing 50 or more pairs of alternating nucleation and outer ceramic layers overlying the first/second nucleation layer and the first/second outer ceramic layer.

14. The method according to any one of claims 11 to 13 comprising depositing the layers using physical vapour deposition (PVD).

15. The method according to any one of claims 11 to 14 wherein the ceramic layers comprise yttria-stablised zirconia or hafnia and the nucleation layer(s) comprise(s) alumina or tantala.
